# EUROPEAN PATENT APPLICATION

(11) **EP 4 783 792 A1**
(43) Date of publication of application: **29.07.2026**
(21) Application number: 25223475.2
(22) Date of filing: 15.12.2025
(51) Int. Cl.: H10H 29/20, H10H 29/32, H10H 29/49

(54) **LIGHT-EMITTING DEVICE**

(30) Priority: 23.12.2024 JP 2024226704
(71) Applicant: Nichia Corporation, Anan-shi, Tokushima 774-8601 (JP)
(72) Inventor: NISHIMORI, Takehiro, Anan-shi, Tokushima, 774-8601 (JP)
(74) Representative: Betten & Resch

(57) **Abstract**

A light-emitting device includes: a support body including: a substrate, and a plurality of conductive members supported by the substrate, the plurality of conductive members including a first conductive part, wherein: the support body has a first recess in an upper surface of the support body; a first light-emitting element disposed on the support body; an integrated circuit extending in a first direction and a second direction orthogonal to the first direction in a top view, the integrated circuit disposed on the support body such that the integrated circuit and the first light-emitting element are in a row in the first direction; a joining member disposed between the support body and the integrated circuit and joining the support body and the integrated circuit; and a first wire connected to the first conductive part and to the integrated circuit.

## Description

### BACKGROUND

The present disclosure relates to a light-emitting device.

For example, Japanese Patent Publication No. 2016-206382 discloses a light-emitting device having a support body, a light-emitting element disposed on the support body, and an integrated circuit disposed on the support body.

### SUMMARY

An object of an embodiment of the present disclosure is to improve the reliability of a light-emitting device.

A light-emitting device according to one embodiment of the present disclosure includes: a support body including a substrate and a plurality of conductive members supported by the substrate, the plurality of conductive members including a first conductive part, the support body having a first recess in an upper surface of the support body; a first light-emitting element disposed on the support body; an integrated circuit extending in a first direction and a second direction orthogonal to the first direction in a top view, the integrated circuit disposed on the support body such that the integrated circuit and the first light-emitting element are in a row in the first direction; a joining member disposed between the support body and the integrated circuit and joining the support body and the integrated circuit; and a first wire connected to the first conductive part and to the integrated circuit. In the first direction, the first recess is located between a connection part, at which the first conductive part and the first wire are connected to each other, and the integrated circuit.

According to certain embodiments of the present disclosure, it is possible to improve the reliability of a light-emitting device.

### BRIEF DESCRIPTION OF THE DRAWINGS

FIG. 1 is a schematic top view of a light-emitting device according to a first embodiment;
FIG. 2 is a schematic cross-sectional view of FIG. 1 along a line II-II;
FIG. 3 is an enlarged view of a region III in FIG. 2;
FIG. 4 is a schematic bottom view of the light-emitting device according to the first embodiment;
FIG. 5 is a schematic top view showing all of a plurality of vias that are formed in a support body in the light-emitting device according to the first embodiment;
FIG. 6 is a schematic top view of a light-emitting device according to a second embodiment;
FIG. 7 is a schematic cross-sectional view of FIG. 6 along a line VII-VII;
FIG. 8 is a schematic top view of a light-emitting device according to a third embodiment;
FIG. 9 is a schematic cross-sectional view of FIG. 8 along a line IX-IX;
FIG. 10 is a schematic top view of a light-emitting device according to a fourth embodiment;
FIG. 11 is a schematic cross-sectional view of FIG. 10 along a line XI-XI;
FIG. 12 is a schematic cross-sectional view of a light-emitting device according to a fifth embodiment;
FIG. 13 is a schematic diagram showing a system configuration of a light-emitting unit according to a sixth embodiment;
FIG. 14 is a schematic top view showing a light-emitting unit according to a first example of a seventh embodiment;
FIG. 15 is a schematic cross-sectional view of FIG. 14 along a line XV-XV;
FIG. 16 is a schematic top view showing a light-emitting unit according to a second example of a seventh embodiment; and
FIG. 17 is a schematic cross-sectional view of FIG. 16 along a line XVII-XVII.

### DETAILED DESCRIPTION

Embodiments will be described below with reference to the drawings. Because the drawings schematically show the embodiments, the scale, spacing, positional relationship, etc. of each member may be exaggerated, or a part of the member may be omitted.

In the following description, components having substantially the same function are indicated by common reference numerals, and their description may be omitted. In addition, there may be cases where terms indicating specific directions or positions (for example, "above," "on top of," "in or on an upper part of," and the like, and "under," "on bottom of," "in or on a lower part of," and the like, and other terms including those terms) are used. However, these terms are used only for the clarity of relative directions or relative positions in the drawings referred to. As long as the same relative directions or relative positions indicated by the terms "above," "on top of," "in or on an upper part of," and the like, and "under," "on bottom of," "in or on a lower part of," and the like in the drawings referred to are ensured, placement on the same positions as in the drawings referred to is not necessary in any drawings other than those of the present disclosure, actual products, and the like. In this specification, "parallel" includes not only the case where two straight lines, sides, surfaces, and the like do not cross even if they are extended, but also the case where two straight lines, sides, surfaces, and the like cross by forming an angle within a range of 10°. In addition, "orthogonal" may include a deviation of ±10° or less from 90°. Positional relations expressed by using the term "above" in this specification include the case in which objects are in contact with each other, and the case in which objects are not in contact with each other and one is located above another.

In this specification, an orthogonal coordinate system having D1, D2, and D3 axes are used as directional expressions. The D1, D2, and D3 axes are orthogonal to each other. The direction along the D1 axis is defined as the first direction D1, the direction along the D2 axis is defined as the second direction D2, and the direction along the D3 axis is defined as the vertical direction. The direction in which the arrow of the D1 axis extends is defined as the front side, and the direction opposite to the front side is defined as the back side. The direction in which the arrow of the D2 axis extends is defined as the right side, and the direction opposite to the right side is defined as the left side. The direction in which the arrow of the D3 axis extends is defined as the upper or top side, and the direction opposite to the upper or top side is defined as the lower or bottom side. A view of an object from above is referred to as a top view. A top view is synonymous with a plan view.

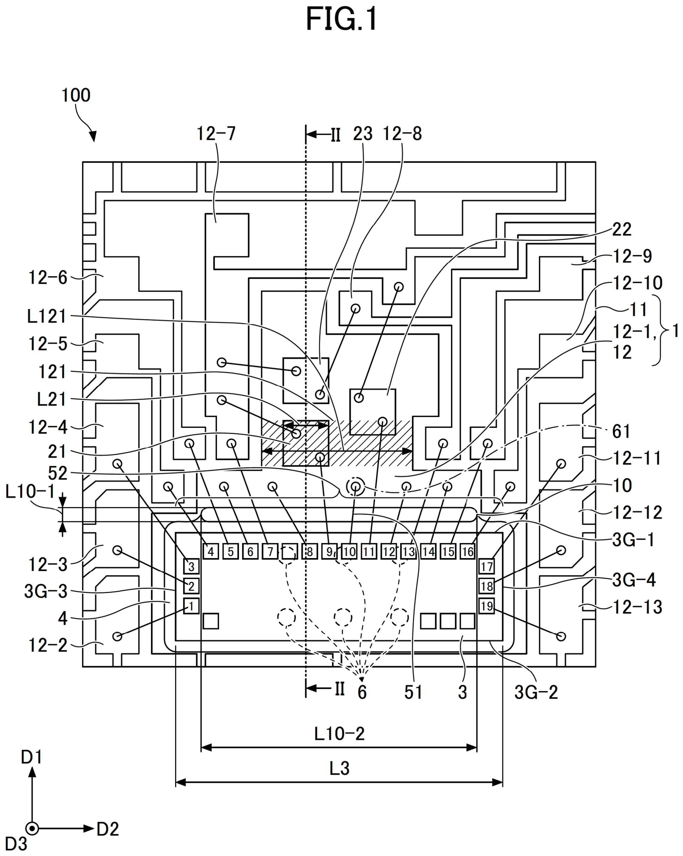

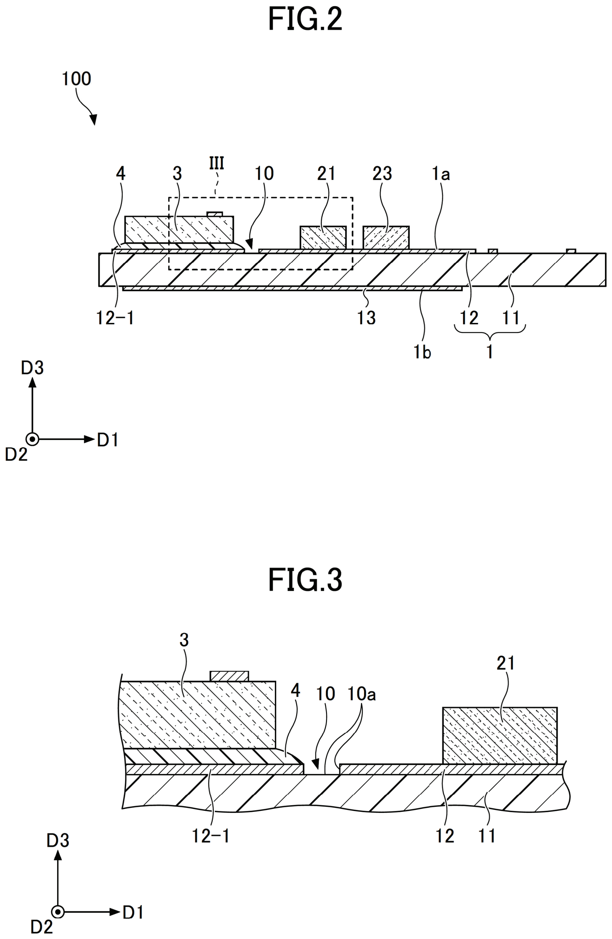

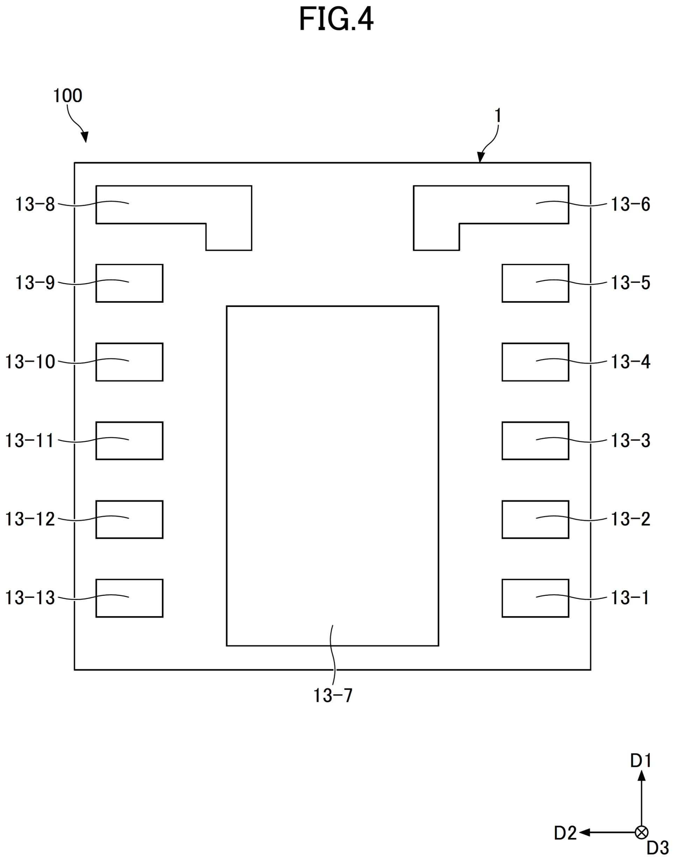

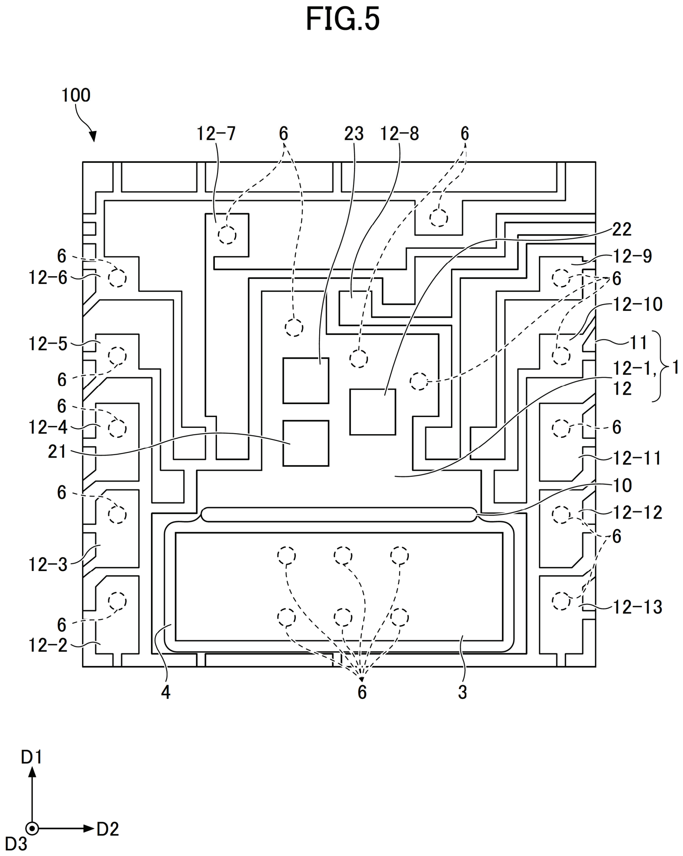

[First Embodiment] A light-emitting device according to a first embodiment will be described with reference to FIGS. 1 to 5. FIG. 1 is a schematic top view of a light-emitting device 100 according to the first embodiment. FIG. 2 is a schematic cross-sectional view of FIG. 1 along a line II-II. FIG. 3 is an enlarged view of a region III in FIG. 2. FIG. 4 is a schematic bottom view of the light-emitting device 100. FIG. 5 is a schematic top view showing all of a plurality of vias 6 formed in a support body 1 in the light-emitting device 100.

As shown in FIGS. 1 to 3, the light-emitting device 100 according to the present embodiment includes a support body 1 including a substrate 11 and a plurality of conductive members 12 supported on the substrate 11, the support body 1 having a first recess 10 in the upper surface of the support body 1, the plurality of conductive members 12 including a first conductive part 12-1. The light-emitting device 100 has a first light-emitting element 21 and an integrated circuit 3 both disposed on the support body 1. In a top view, the integrated circuit 3 has a first direction D1 and a second direction D2 orthogonal to the first direction D1. The integrated circuit 3 is side by side with the first light-emitting element 21 in the first direction D1. The light-emitting device 100 also includes a joining member 4 disposed between the support body 1 and the integrated circuit 3 and joining the support body 1 and the integrated circuit 3, and a first wire 51 connected to the first conductive part 12-1 and to the integrated circuit 3.

In the example shown in FIGS. 1 to 3, the light-emitting device 100 includes a second light-emitting element 22 and a third light-emitting element 23 both disposed on the support body 1, and a plurality of second wires 52 each connected to the integrated circuit 3. The plurality of second wires 52 include the first wire 51. The support body 1 has a plurality of vias 6 electrically connected to the first conductive part 12-1. The first conductive part 12-1 includes a part that is located in the center of the support body 1, and the first light-emitting element 21, the second light-emitting element 22, and the third light-emitting element 23 are disposed on the upper surface of the first conductive part 12-1. In the example shown in FIG. 1, six vias 6 each electrically connected to the first conductive part 12-1 are formed in the support body 1. The length of the integrated circuit 3 in the second direction D2 is longer than the length of the integrated circuit 3 in the first direction D1. The light-emitting device 100 may further include wires other than the plurality of second wires 52, and may further include conductive members other than the plurality of conductive members 12. To prevent the drawing from being complicated, only the six vias 6 each electrically connected to the first conductive part 12-1 are shown in the example shown in FIG. 1, and the vias 6 are not shown in the example shown in FIG. 4. All the vias 6 that are formed in the support body 1 will be described with reference to FIG. 5.

As shown in FIGS. 2 and 3, the first recess 10 is a part recessed downward from the upper surface 1a of the support body 1. The first light-emitting element 21, the second light-emitting element 22, the third light-emitting element 23, and the integrated circuit 3 are disposed on the upper surface 1a of the support body 1. In the example shown in FIGS. 2 and 3, the upper surface 1a of the support body 1 is composed of the upper surfaces of the conductive members 12. In the example shown in FIGS. 1 to 3, the first recess 10 is composed of a hole that is formed in a part of the conductive member 12 disposed on the substrate 11, and that extends through the conductive member 12 from the upper surface to the lower surface thereof. In a top view, no hole or depression is formed in a part of the substrate 11 that coincides with the hole formed in the conductive member 12. The inner surfaces 10a of the first recess 10 are defined by the substrate 11 and the conductive member 12. In the example shown in FIGS. 2 and 3, the inner surfaces 10a of the first recess 10 include a part of the upper surface of the substrate 11 and a part of a lateral surface of the conductive member 12.

However, the first recess 10 is not limited to the above-described hole penetrating the conductive member 12 from the upper surface to the lower surface thereof. For example, the first recess 10 may be composed of a depression that does not penetrate the conductive member 12, or may be composed of a hole penetrating the conductive member 12 and the substrate 11 from the upper surface of the conductive member 12 to the lower surface of the substrate 11. Further, the first recess 10 may be composed of a hole penetrating the conductive member 12 from the upper surface to the lower surface thereof, and a depression that coincides with the hole in a top view and that does not penetrate the substrate 11. The lower surface 1b of the support body 1 is the lowermost surface of the support body 1. In the example shown in FIG. 2, a lower interconnect 13 is disposed on the surface of the support body 1 opposite to the surface on which the conductive member 12 is disposed. The lower surface 1b of the support body 1 is the lower surface of the lower interconnect 13.

As shown in FIG. 1, in the first direction D1, the first recess 10 is located between a connection part 61 at which the first conductive part 12-1 and the first wire 51 are connected to each other and the integrated circuit 3. In the example shown in FIG. 1, in the top view, the first recess 10 has a substantially rectangular outer shape that is elongated in the second direction D2, and the two ends of the first recess 10 in the second direction D2 include curved surfaces. However, the outer shape of the first recess 10 in the top view is not limited to the substantially rectangular shape, and may be a substantially square shape, a substantially circular shape, a substantially elliptical shape, a substantially polygonal shape, and the like. In a top view, the first recess 10 may have a shape including a bent part or a curved part. Furthermore, in a top view, the first recess 10 may extend in a direction other than the second direction D2, and may extend in a plurality of directions.

In the manufacturing process of a typical light-emitting device, for example, after an integrated circuit is joined to a support body by a joining member disposed on the support body, a wire to be connected to the integrated circuit is disposed. Because the joining member has fluidity until it cures after being disposed on the support body, it may spread over the support body due to wettability. When the joining member that wet-spreads on the support body reaches the connection part at which the wire and a conductive part are connected to each other, it becomes difficult to arrange the wire because the joining member is located at the connection part. In addition, the joining strength between the wire and the conductive part at the connection part may decrease due to the joining member being located at the connection part.

In the present embodiment, in the first direction D1, the first recess 10 is located between the connection part 61 at which the first conductive part 12-1 and the first wire 51 are connected to each other and the integrated circuit 3. Even when the joining member 4 disposed on the support body 1 wet-spreads on the support body 1 in the manufacturing process of the light-emitting device 100, the first recess 10 inhibits the joining member 4 from wet-spreading toward the connection part 61. Accordingly, the joining member 4 can be inhibited from wet-spreading to the connection part 61. This can facilitate arrangement of the first wire 51 after the integrated circuit 3 is joined to the support body 1, and can inhibit a decrease in the joining strength between the first wire 51 and the connection part 61. Inhibiting a decrease in the joining strength between the first wire 51 and the connection part 61 allows for improving the reliability of the light-emitting device 100 in the present embodiment.

The support body 1 of the light-emitting device 100 may have a projection that is disposed at the position of the first recess 10. The projection is a part projecting upward from the upper surface 1a of the support body 1. In a top view, the projection may have a substantially rectangular outer shape that is elongated in the second direction D2 and of which both ends in the second direction D2 include curved surfaces. However, the outer shape of the projection in a top view is not limited to the substantially rectangular shape, and may be a substantially square shape, a substantially circular shape, a substantially elliptical shape, a substantially polygonal shape, and the like. In a top view, the projection may have a shape including a bent part or a curved part. Furthermore, the projection may extend in a direction other than the second direction D2 and may extend in a plurality of directions. The support body 1 of the light-emitting device 100 may include the first recess and a projection located near the first recess.

As shown in FIG. 1, it is preferable that the maximum length L10-2 of the first recess 10 in the second direction D2 is longer than the maximum length L10-1 of the first recess 10 in the first direction D1. With the maximum length L10-2 longer than the maximum length L10-1, the first recess 10 can extend over a wide range in the second direction D2 compared with a case where the maximum length L10-2 is equal to or less than the maximum length L10-1. Accordingly, over a wide area, the joining member 4 wet-spreading on the support body 1 can be inhibited from extending toward the connection part 61. As a result, the joining member 4 wet-spreading on the support body 1 is less likely to reach the connection part 61, allowing for improving the reliability of the light-emitting device 100.

From the viewpoint of reducing spreading of the joining member 4 to the connection part 61, it is preferable that the maximum length L10-2 is equal to or greater than two times, equal to or greater than five times, or equal to or greater than ten times the maximum length L10-1. From the viewpoint of reducing the size of the light-emitting device 100, it is preferable that the maximum length L10-2 is equal to or greater than a hundred times the maximum length L10-1.

In the light-emitting device 100, the inner surfaces 10a of the first recess 10 are defined by the substrate 11 and the conductive member 12. With this structure, even when the joining member 4 that wet-spreads on the support body 1 flows into the first recess 10, the joining member 4 comes into contact with the inner surfaces 10a of the first recess 10, and thus can be inhibited from further wet-spreading in the direction toward the first light-emitting element 21. Accordingly, the joining member 4 wet-spreading on the support body 1 is less likely to reach the connection part 61, thereby improving the reliability of the light-emitting device 100. In the light-emitting device 100, the bottom surface of the first recess 10 is defined by the substrate 11, and the inner lateral surface of the first recess 10 is defined by the conductive member 12.

As shown in FIG. 1, it is preferable that the maximum length L10-2 of the first recess 10 is longer than the maximum length L21 of the first light-emitting element 21 in the second direction D2. For example, in many cases, the connection part 61 is disposed near the first light-emitting element 21. With the maximum length L10-2 longer than the maximum length L21, the first recess 10 can extend over a wide range in the second direction D2 near the first light-emitting element 21, and the joining member 4 that wet-spreads on the support body 1 can be inhibited, over a wide area, from extending toward the connection part 61. Accordingly, the joining member 4 that wet-spreads on the support body 1 is less likely to reach the connection part 61, so that the reliability of the light-emitting device 100 can be improved.

In the example shown in FIG. 1, among the plurality of conductive members 12, one conductive member 12 located immediately under the first light-emitting element 21 includes a first part 121, the first part 121 being a region that, in a top view, overlaps the first light-emitting element 21 in the second direction D2. In FIG. 1, the first part 121 is represented by diagonal hatching from bottom left to top right. In the light-emitting device 100, it is preferable that the maximum length L10-2 of the first recess 10 is longer than the maximum length L121 of the first part 121 in the second direction D2. With the maximum length L10-2 longer than the maximum length L121, the first recess 10 can extend over a wide area in the second direction D2 near the first light-emitting element 21, and the joining member 4 wet-spreading on the support body 1 can be inhibited, over a wide area, from extending toward the connection part 61. Accordingly, the joining member 4 that wet-spreads on the support body 1 is less likely to reach the connection part 61, so that the reliability of the light-emitting device 100 can be improved.

As shown in FIG. 1, it is preferable that the maximum length L10-2 of the first recess 10 is shorter than the maximum length L3 of the integrated circuit 3 in the second direction D2. For example, in many cases, the length of the light-emitting device 100 in the second direction D2 is determined by the maximum length L3 of the integrated circuit 3. With the maximum length L10-2 shorter than the maximum length L3, it is possible to inhibit increase in a length of the light-emitting device 100 in the second direction D2. This facilitates reduction of the size of the light-emitting device 100.

As shown in FIG. 1, it is preferable that the integrated circuit 3 is located on the first conductive part 12-1. With the integrated circuit 3 located on the first conductive part 12-1, the connection part 61 can be located closer to the integrated circuit 3 in the first direction D1 than when the integrated circuit 3 is located on any conductive member 12 other than the first conductive part 12-1 among the plurality of conductive members 12. This can inhibit increase in a length of the light-emitting device 100 in the first direction D1. This facilitates reduction of the size of the light-emitting device 100. Moreover, reduction in distance from the integrated circuit 3 to the connection part 61 allows reduction in a length of the first wire 51. This can facilitate arrangement of the first wire 51 in the process of manufacturing the light-emitting device 100.

As shown in FIG. 1, in a top view, the integrated circuit 3 has a first outer edge 3G-1 facing the first light-emitting element 21, a second outer edge 3G-2 located on a side opposite to the first outer edge 3G-1, a third outer edge 3G-3 connected to each of the first outer edge 3G-1 and the second outer edge 3G-2, and a fourth outer edge 3G-4 located on a side opposite to the third outer edge 3G-3. In a top view, the plurality of second wires 52 do not overlap the second outer edge 3G-2. For example, if the plurality of second wires 52 are disposed to overlap the second outer edge 3G-2 in a top view, one end of each of the plurality of second wires 52 is connected to the integrated circuit 3, and the support body 1 needs to include, at a location outside the second outer edge 3G-2 of the integrated circuit 3, a region to which the other end of each of the plurality of second wires 52 is to be connected. Accordingly, a length of the support body 1 in the first direction D1 may be increased, which may result in increase in the size of the light-emitting device 100. When the plurality of second wires 52 do not overlap the second outer edge 3G-2 in a top view, the support body 1 does not need to include, at a location outside the second outer edge 3G-2 of the integrated circuit 3, the region to which the other end of each of the plurality of second wires 52 is to be connected. This can inhibit increase in a length of the support body 1 in the first direction D1, and thus can facilitate reduction of the size of the light-emitting device 100.

As shown in FIG. 1, it is preferable that the integrated circuit 3 overlaps the vias 6 in a top view. With the vias 6 arranged to overlap the integrated circuit 3 that easily generates heat by being driven in a top view, it is possible to release the heat radiated from the integrated circuit 3 through the vias 6 to an external substrate or the like on which the support body 1 is disposed. Thus, the temperature rise of the integrated circuit 3 and the light-emitting device 100 can be reduced. Accordingly thermal influence on the integrated circuit 3 and on the light-emitting device 100 can be reduced, which allows for improving the reliability of the light-emitting device 100.

Hereinafter, each constituent component of the light-emitting device 100 will be described in detail.

### (Support body 1)

The support body 1 is a member on which the first light-emitting element 21, the second light-emitting element 22, and the third light-emitting element 23 are mounted. The first light-emitting element 21, the second light-emitting element 22, and the third light-emitting element 23 are joined to the upper surface 1a of the support body 1 by, for example, a joining member, such as resin, solder, a conductive paste, and the like.

In the example shown in FIG. 1, the light-emitting device 100 includes, in addition to the first conductive part 12-1, a conductive member 12-2, a conductive member 12-3, a conductive member 12-4, a conductive member 12-5, a conductive member 12-6, a conductive member 12-7, a conductive member 12-8, a conductive member 12-9, a conductive member 12-10, a conductive member 12-11, a conductive member 12-12, and a conductive member 12-13.

The conductive member 12-2 is located on the left side of the integrated circuit 3 and has a substantially rectangular outer shape that is elongated in the first direction D1 in a top view. The conductive member 12-3 is located on the front side of the conductive member 12-2 and has a substantially rectangular outer shape that is elongated in the first direction D1 in a top view. The conductive member 12-4 is located on the front side of the conductive member 12-3 and has a substantially rectangular outer shape that is elongated in the first direction D1 in a top view. The conductive member 12-5 is located on the front side of the conductive member 12-4 and has a substantially square outer shape in a top view. The conductive member 12-6 is located on the front side of the conductive member 12-5 and has a shape extending frontward from a part located on a left side of the first conductive part 12-1 and also extending rightward from a part that is located near the front end of the support body 1 in a top view.

The conductive member 12-7 is located on the right side of the conductive member 12-6 and has a shape extending frontward from a part located on a left side of the first conductive part 12-1 and also extending rightward from a part that is located near the front end of the support body 1 in a top view. The conductive member 12-8 is located on the front side of the first conductive part 12-1 in a top view and has a shape branching from a part located on the front side of the first conductive part 12-1, into a part extending rightward and a part extending backward in a top view. The conductive member 12-9 is located on the right side of the first conductive part 12-1 and has a substantially square outer shape in a top view. The conductive member 12-10 is located on the back side of the conductive member 12-9 and has a substantially square outer shape in a top view. The conductive member 12-11 is located on the back side of the conductive member 12-10 and has a substantially rectangular outer shape that is elongated in the first direction D1 in a top view. The conductive member 12-12 is located on the back side of the conductive member 12-11 and has a substantially rectangular outer shape that is elongated in the first direction D1 in a top view. The conductive member 12-13 is located on the back side of the conductive member 12-12 and has a substantially rectangular outer shape that is elongated in the first direction D1 in a top view.

A wiring board including the substrate 11 and interconnect can be used as the support body 1. The first recess 10 is defined by the substrate 11 and the wiring. The substrate 11 can be composed of a resin, a ceramic, glass, and the like. As the resin, publicly-known materials, such as thermosetting resin and thermoplastic resin can be used. Examples of the ceramic include aluminum oxide, aluminum nitride, zirconium oxide, zirconium nitride, titanium oxide, and titanium nitride, a mixture thereof, and the like. Examples of wiring include copper, iron, nickel, tungsten, chromium, aluminum, silver, gold, titanium, palladium, and rhodium, alloys thereof, and the like. These metals or alloys may be a single layer or a multilayer. The substrate 11 may contain a molded resin having a plurality of leads.

For the first conductive part 12-1 and the conductive members, leads having conductivity and functioning as electrodes for supplying power to the first light-emitting element 21, the second light-emitting element 22, and the third light-emitting element 23, and/or the integrated circuit may be used. As the base material of the leads, metals, such as copper, aluminum, gold, silver, iron, and nickel, or alloys thereof, phosphor bronze, iron-containing copper, and the like may be used. The base material may be a single layer or a laminated structure (for example, a clad material). In particular, it is preferable to use copper, which is inexpensive and has a high heat dissipation performance, as the base material. The leads may have a metal layer on the surface of the base material. Gold, silver, aluminum, nickel, palladium, rhodium, and copper, or alloys thereof, and the like may be used as the metal layer. The metal layer may be provided on the entirety or a part of the surface of the leads. Moreover, as the metal layer, a layer used in a region formed on the upper surface of the leads and a layer used in a region formed on the lower surface of the leads may be different. For example, the metal layer formed on the upper surface of the leads is a metal layer including a plurality of layers containing nickel and silver, and the metal layer formed on the lower surface of the leads is a metal layer containing no nickel metal layer. A metal layer, such as gold and the like, formed on the upper surface of the leads may be thicker than a metal layer, such as gold and the like, formed on the lower surface of the leads. When a metal layer containing silver is formed on the uppermost surface of the leads, it is preferable to provide a protective layer, such as silicon oxide and the like, on the surface of the metal layer containing silver. Thus, discoloration of the metal layer containing silver due to any sulfur components and the like contained in the open air can be inhibited. The protective layer can be formed by a vacuum process, such as sputtering and the like.

The first conductive part 12-1 may only need to be a conductive member through which a current can flow, and a current for causing the first light-emitting element 21, the second light-emitting element 22 and/or the third light-emitting element 23 to emit light does not necessarily need to flow through the first conductive part 12-1. The first conductive part 12-1 can also be used as a heat dissipation part of the light-emitting device 100. The first conductive part 12-1 can be composed of a metal and the like having conductivity and a good heat dissipation performance.

As shown in FIG. 4, lower interconnect 13-1, lower interconnect 13-2, lower interconnect 13-3, lower interconnect 13-4, lower interconnect 13-5, lower interconnect 13-6, lower interconnect 13-7, lower interconnect 13-8, lower interconnect 13-9, lower interconnect 13-10, lower interconnect 13-11, lower interconnect 13-12, and lower interconnect 13-13 are disposed on the lower surface of the support body 1.

### (First Light-Emitting Element 21, Second Light-Emitting Element 22, and Third Light-Emitting Element 23)

In the example shown in FIG. 1, the first light-emitting element 21, the second light-emitting element 22, and the third light-emitting element 23 are disposed in the center of the support body 1. By disposing the first light-emitting element 21, the second light-emitting element 22, and the third light-emitting element 23 in the center of the support body 1, it is possible to dispose the first light-emitting element 21, the second light-emitting element 22, and the third light-emitting element 23 at a high density. In other words, it is possible to shorten the distance from the first light-emitting element 21 to the second light-emitting element 22 and the distance from the first light-emitting element 21 to the third light-emitting element 23. In addition, even if the first light-emitting element 21, the second light-emitting element 22, and the third light-emitting element 23 are mounted at positions rotated about the center of the light-emitting device 100, their positional shift can be less than when the first light-emitting element 21, the second light-emitting element 22, and the third light-emitting element 23 are located near the corners of the light-emitting device.

The first light-emitting element 21, the second light-emitting element 22, and the third light-emitting element 23 each include a semiconductor laminate. The semiconductor laminate includes, for example, a substrate, such as sapphire, gallium nitride, and the like, an n-type semiconductor layer disposed on the substrate, a p-type semiconductor layer, and a light-emitting layer sandwiched between the n-type semiconductor layer and the p-type semiconductor layer. The first light-emitting element 21, the second light-emitting element 22, and the third light-emitting element 23 each include an n-side electrode electrically connected to the n-type semiconductor layer, and a p-side electrode electrically connected to the p-type semiconductor layer. The n-side electrode and the p-side electrode form part of the upper surface of each of the first light-emitting element 21, the second light-emitting element 22, and the third light-emitting element 23. Note that the first light-emitting element 21, the second light-emitting element 22, and the third light-emitting element 23 do not need to include the substrate, such as sapphire, gallium nitride, and the like. This makes it easy to reduce the size of the first light-emitting element 21, the second light-emitting element 22, and the third light-emitting element 23.

The structure of the light-emitting layer may be a structure having a single active layer, as in a double hetero structure and a single quantum well structure (SQW), or may be a structure having a group of active layers, as in a multiple quantum well structure (MQW). The light-emitting layer can emit visible light or ultraviolet light. The light-emitting layer can emit visible light in a range from blue to red. The semiconductor laminate including such a light-emitting layer may contain, for example, InxAlyGa1-x-yN (0£x, 0£y, x+y£1). The semiconductor laminate may include at least one light-emitting layer capable of emitting the light described above. For example, the semiconductor laminate may have a structure including one or more light-emitting layers between the n-type semiconductor layer and the p-type semiconductor layer, or may have a structure in which the structure including the n-type semiconductor layer, the light-emitting layer, and the p-type semiconductor layer in this order is repeated a plurality of times. When the semiconductor laminate includes a plurality of light-emitting layers, the semiconductor laminate may include light-emitting layers having different light emission peak wavelengths, or may include light-emitting layers having the same light emission peak wavelength. When light-emitting layers have the same light emission peak wavelength, the light emission peak wavelength may vary by, for example, some nanometers. Combinations of such light-emitting layers can be appropriately selected. For example, when the semiconductor laminate includes two light-emitting layers, it is possible to select the light-emitting layers as a combination of blue light and blue light, a combination of green light and green light, a combination of red light and red light, a combination of ultraviolet light and ultraviolet light, a combination of blue light and green light, a combination of blue light and red light, a combination of green light and red light, and the like. The light-emitting layers may include a plurality of active layers having different light emission peak wavelengths, or may include a plurality of active layers having the same light emission peak wavelength.

The first light-emitting element 21 emits light including a first peak wavelength. A wavelength, within the light spectrum emitted from the first light-emitting element 21, that has the maximum power output is defined as the first peak wavelength. In the example shown in FIGS. 1 to 4, the first light-emitting element 21 emits blue light. The first light-emitting element 21 may emit green light, red light, and the like.

The second light-emitting element 22 emits light including a second peak wavelength different from the first peak wavelength. A wavelength, within the light spectrum emitted from the second light-emitting element 22, that has the maximum power output is defined as the second peak wavelength. In the example shown in FIGS. 1 to 4, the second light-emitting element 22 emits green light. The second light-emitting element 22 may emit blue light, red light, and the like.

The third light-emitting element 23 emits light including a third peak wavelength different from the first peak wavelength and the second peak wavelength. A wavelength, the light spectrum emitted from the third light-emitting element 23, that has the maximum power output is defined as the third peak wavelength. In the example shown in FIGS. 1 to 4, the third light-emitting element 23 emits red light. The third light-emitting element 23 may emit blue light, green light, and the like.

The light-emitting device 100 is not limited to including the first light-emitting element 21, the second light-emitting element 22, and the third light-emitting element 23, and may include one or more light-emitting elements that are disposed on the support body 1. The positions at which one or more light-emitting elements are disposed may be determined appropriately.

### (Integrated Circuit 3)

In the example shown in FIG. 1, the integrated circuit 3 is an electronic circuit, such as a large scale integrated circuit (Large Scale Integration (LSI)) and the like, for driving the first light-emitting element 21, the second light-emitting element 22, and the third light-emitting element 23 to emit light. A drive signal for the integrated circuit 3 is supplied to the integrated circuit 3 via the conductive member 12-5. As the integrated circuit 3, for example, one that has the following specifications and functions may be used. However, the specifications and functions of the integrated circuit 3 are not limited to the following.
- 488 Hz, 12-bit Pulse Width Modulation (PWM) control
- Temperature correction function
- 8-bit luminance resolution (Red, Green, and Blue)
- Dimming function
- Daisy chain connectability up to 4,079 light-emitting devices, such as Light Emitting Diodes (LEDs) and the like
- Capable of performing bidirectional communication and half-duplex communication
- Supporting sixteen multicast address groups
- Having a built-in oscillator (OSC)
- Maximum length in the first direction D1: 0.73 mm
- Maximum length in the second direction D2: 2.29 mm

In FIG. 1, the numerals 1 to 19 assigned within the integrated circuit 3 indicate the pin numbers of a plurality of pins provided in the integrated circuit 3, respectively. The names, types, and descriptions of the pins corresponding to the pin numbers are shown in Table 1 below. Chip select signals in Table 1 mean signals selecting any of the first light-emitting element 21, the second light-emitting element 22, or the third light-emitting element 23 provided on the light-emitting device 100.

**Table 1**

| **Pin number** | **Pin name** | **Type** | **Description** | **Connected to** |
|---|---|---|---|---|
| **1** | **SDO_OUT** | **OUT** | **Data output** | **Conductive member 12-2** |
| **2** | **SDI_IN** | **IN** | **Data signal input** | **Conductive member 12-3** |
| **3** | **SCLK_IN** | **IN** | **Clock signal input** | **Conductive member 12-4** |
| **4** | **CSX_IN** | **IN** | **Chip select signal input** | **Conductive member 12-5** |
| **5** | **IOVCC_IN** | **IN** | **LDO input (1.8 V)** | **Conductive member 12-6** |
| **6** | **DGND** | **GND** | **Ground** | **First conductive part 12-1** |
| **7** | **VCC5** | **Power** | **DC power source voltage** | **Conductive member 12-7** |
| **8** | **AGND** | **GND** | **Ground** | **First conductive part 12-1** |
| **9** | **BLUE** | **OUT** | **output to first light-emitting element** | **First light-emitting element 21** |
| **10** | **PGND1** | **GND** | **Power ground of first light-emitting element** | **First conductive part 12-1** |
| **11** | **RED** | **OUT** | **Output to third light-emitting element** | **Third light-emitting element 23** |
| **12** | **PGND2** | **GND** | **Power ground of third light-emitting element** | **First conductive part 12-1** |
| **13** | **GREEN** | **OUT** | **Output to second light-emitting element** | **Conductive member 12-8, Second light-emitting element 22** |
| **14** | **PGND3** | **GND** | **Power ground of second light-emitting element** | **First conductive part 12-1** |
| **15** | **IOVCC_OUT** | **OUT** | **LDO output (1.8 V)** | **Conductive member 12-9** |
| **16** | **CSX_OUT** | **OUT** | **Chip select signal output** | **Conductive member 12-10** |
| **17** | **SCLK_OUT** | **OUT** | **Clock signal output** | **Conductive member 12-11** |
| **18** | **SDI_OUT** | **OUT** | **Data signal output** | **Conductive member 12-12** |
| **19** | **SDO_IN** | **IN** | **Data input** | **Conductive member 12-3** |

In the example shown in FIG. 1, the pin of the integrated circuit 3 having the pin number 1 is connected to the conductive member 12-2. The pin of the integrated circuit 3 having the pin number 2 is connected to the conductive member 12-3. The pin of the integrated circuit 3 having the pin number 3 is connected to the conductive member 12-4. The pin of the integrated circuit 3 having pin number 4 is connected to the conductive member 12-5. The pin of the integrated circuit 3 having the pin number 5 is connected to the conductive member 12-6. The pin of the integrated circuit 3 having the pin number 6 is connected to the first conductive part 12-1. The pin of the integrated circuit 3 having the pin number 7 is connected to the conductive member 12-7. The pin of the integrated circuit 3 having the pin number 8 is connected to the first conductive part 12-1. The pin of the integrated circuit 3 having the pin number 9 is connected to the first light-emitting element 21. The pin of the integrated circuit 3 having the pin number 10 is connected to the first conductive part 12-1. The pin of the integrated circuit 3 having the pin number 11 is connected to the second light-emitting element 22. The pin of the integrated circuit 3 having the pin number 12 is connected to the first conductive part 12-1. The pin of the integrated circuit 3 having the pin number 13 is connected to the conductive member 12-8 and to the third light-emitting element 23. The pin of the integrated circuit 3 having the pin number 14 is connected to the first conductive part 12-1. The pin of the integrated circuit 3 having the pin number 15 is connected to the conductive member 12-9. The pin of the integrated circuit 3 having the pin number 16 is connected to the conductive member 12-10. The pin of the integrated circuit 3 having the pin number 17 is connected to the conductive member 12-11. The pin of the integrated circuit 3 having the pin number 18 is connected to the conductive member 12-12. The pin of the integrated circuit 3 having the pin number 19 is connected to the conductive member 12-13. The positions of the pins are not particularly limited. For example, instead of the pin having the pin number 8 connected to the first conductive part 12-1, a pin located between the pin having the pin number 8 and the pin having the pin number 9 may be connected to the first conductive part 12-1.

In the integrated circuit 3, the pin having the pin number 10 is disposed between the pin having the pin number 9, which is the output pin to the first light-emitting element 21, and the pin having the pin number 11, which is the output pin to the third light-emitting element 23. For example, the vicinities of output pins that control currents to the light-emitting elements tend to be subject to temperature rise. Disposing another pin between the output pin to the first light-emitting element 21 and the output pin to the third light-emitting element 23 makes the distance between these output pins shorter than when the output pin to the first light-emitting element 21 and the output pin to the third light-emitting element 23 are adjacent. This facilitates reduction of the temperature rise of the integrated circuit 3.

In the integrated circuit 3, the pin having the pin number 10, which is the power ground pin of the first light-emitting element 21, is disposed next to the pin having the pin number 9, which is the output pin to the first light-emitting element 21. This makes the levels of external noise applied to the output pin to the first light-emitting element 21 and to the power ground pin of the first light-emitting element 21 approximately equal. This cancels the external noise, facilitates reduction of the impact of the external noise, and also facilitates reduction of internal noise applied to the output pin to the first light-emitting element 21.

In the example shown in FIG. 5, in a top view, the support body 1 has twelve vias 6 for electrical connection, that correspond to the conductive member 12-2, the conductive member 12-3, the conductive member 12-4, the conductive member 12-5, the conductive member 12-6, the conductive member 12-7, the conductive member 12-9, the conductive member 12-10, the conductive member 12-11, the conductive member 12-12, and the conductive member 12-13. More specifically, one via 6 is formed in one-to-one correspondence with each conductive member 12 other than the conductive member 12-6 among the plurality of conductive members 12. On the other hand, two vias 6 are formed in the conductive member 12-6. Nine vias 6 each electrically connected to the first conductive part 12-1 are formed in the first conductive part 12-1. However, the positions on the support body 1 at which the plurality of vias 6 are formed, the numbers of vias 6, and the like can be appropriately changed according to the application and the like of the light-emitting device.

In the example shown in FIGS. 1, 4, and 5, the conductive member 12-2 is electrically connected to the lower interconnect 13-1 via the corresponding via 6. The conductive member 12-3 is electrically connected to the lower interconnect 13-2 via the corresponding via 6. The conductive member 12-4 is electrically connected to the lower interconnect 13-3 via the corresponding via 6. The conductive member 12-5 is electrically connected to the lower interconnect 13-4 via the corresponding via 6. The conductive member 12-6 is electrically connected to the lower interconnect 13-5 and the lower interconnect 13-8 via the corresponding vias 6. The conductive member 12-7 is electrically connected to the lower interconnect 13-6 via the corresponding via 6. The conductive member 12-8 is electrically connected to the lower interconnect 13-7 via the corresponding via 6. The conductive member 12-9 is electrically connected to the lower interconnect 13-9 via the corresponding via 6. The conductive member 12-10 is electrically connected to the lower interconnect 13-10 via the corresponding via 6. The conductive member 12-11 is electrically connected to the lower interconnect 13-11 via the corresponding via 6. The conductive member 12-12 is electrically connected to the lower interconnect 13-12 via the corresponding via 6. The conductive member 12-13 is electrically connected to the lower interconnect 13-13 via the corresponding via 6.

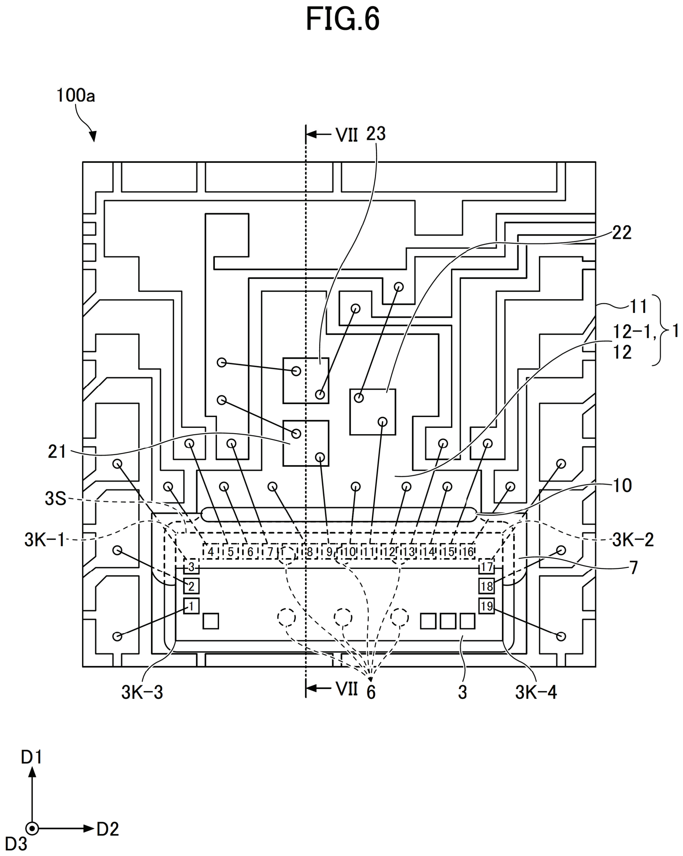

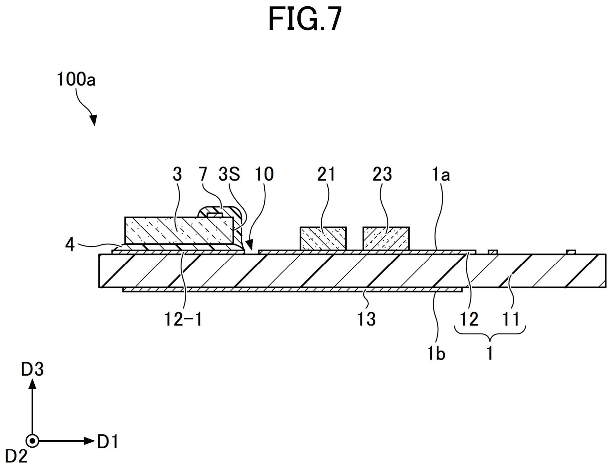

[Second Embodiment] Next, a light-emitting device according to a second embodiment will be described with reference to FIGS. 6 and 7. FIG. 6 is a schematic top view of a light-emitting device 100a according to the second embodiment. FIG. 7 is a schematic cross-sectional view of FIG. 6 along a line VII-VII. Note that names and reference signs that are the same as those used in the embodiment already described indicate the same or the same type of members or components, and detailed description thereof will be omitted appropriately. This also applies to the description of the embodiments to be shown below.

As shown in FIGS. 6 and 7, the light-emitting device 100a according to the present embodiment is different from the light-emitting device 100 according to the first embodiment in that it further includes a reflective member 7 that covers at least a part of a lateral surface 3S of the integrated circuit 3 facing the first light-emitting element 21.

In the example shown in FIGS. 6 and 7, the integrated circuit 3 has a substantially rectangular outer shape in a top view. Among four corners 3K-1, 3K-2, 3K-3, and 3K-4 of the integrated circuit 3 in a top view, the two corners 3K-1 and 3K-2 located at a side of the first light-emitting element 21 are covered by the reflective member 7. On the other hand, the two corners 3K-3 and 3K-4 located on a side opposite to the side of the first light-emitting element 21 are exposed from the reflective member 7.

For example, when a part of light emitted from the first light-emitting element 21 enters the integrated circuit 3, the light is absorbed by the integrated circuit 3, which might reduce the light extraction efficiency of the light-emitting device 100a. In the present embodiment, at least a part of the lateral surface 3S of the integrated circuit 3 facing the first light-emitting element 21 is covered with the reflective member 7, such that the light emitted from the first light-emitting element 21 and travelling toward the integrated circuit 3 is reflected by the reflective member 7. As a result, the light travelling toward the integrated circuit 3 is less absorbed by the integrated circuit 3, and contributes to the light to be emitted from the light-emitting device 100a. As a result, the light extraction efficiency of the light-emitting device 100a is improved in the present embodiment.

In addition, for example, in a case of covering the corner 3K-3 and the corner 3K-4 of the integrated circuit 3 with the reflective member 7, a certain amount of a region where the reflective member 7 is to be disposed needs to be secured on the outer side (for example, on the back side) of the integrated circuit 3 on the support body 1 in a top view. This might expand the size of the light-emitting device. In the present embodiment, only the corner 3K-1 and the corner 3K-2, among the corner 3K-1, the corner 3K-2, the corner 3K-3, and the corner 3K-4 of the integrated circuit 3, are covered with the reflective member 7. As a result, no region where the reflective member 7 is to be disposed needs to be secured on the outer side of the integrated circuit 3 on the support body 1 in a top view. As a result, according to the light-emitting device 100a, it is possible to reduce the size of the light-emitting device 100a, compared with a case where all of the corner 3K-1, the corner 3K-2, the corner 3K-3 and the corner 3K-4 are covered with the reflective member 7.

Further, the corner 3K-1 and the corner 3K-2 being covered with the reflective member 7 reduces peeling of the integrated circuit 3 from the support body 1. Furthermore, exposing the corner 3K-3 and the corner 3K-4 located on the side opposite to the first light-emitting element 21 from the reflective member 7 reduces the volume of the reflective member 7. The more the volume reduction of the reflective member 7, the easier it is to reduce shape variation of the reflective member 7. Thus, for example, when using a plurality of light-emitting devices 100a, it is easier to reduce appearance variation among the plurality of light-emitting devices 100a.

### (Reflective Member 7)

The reflective member 7 is a member having reflectivity of light emitted from the first light-emitting element 21, the second light-emitting element 22, and the third light-emitting element 23. In this specification, "having reflectivity" means that the reflectance of the emission peak wavelength of at least one of the first light-emitting devices 21, the second light-emitting element 22, and the third light-emitting element 23 is 50% or higher. However, from the viewpoint of improving the light extraction efficiency of the light-emitting device 100a, it is preferable that the reflectance of the emission peak wavelength of each of the first light-emitting element 21, the second light-emitting element 22, and the third light-emitting element 23 is 50% or higher.

The reflective member 7 includes, for example, a resin material serving as a base material and a light reflective substance. As the resin material of the reflective member 7, a thermosetting resin, a thermoplastic resin, and the like can be used. As a thermoplastic resin, polyphthalamide resin, polybutylene terephthalate (PBT), unsaturated polyester, and the like can be used. As a thermosetting resin, epoxy resin, modified epoxy resin, silicone resin, modified silicone resin, and the like can be used. In particular, as the resin material, it is preferable to use a thermosetting resin, such as epoxy resin, silicone resin, and the like having excellent heat resistance and light resistance.

It is preferable that the reflective member 7 contains the light-reflecting substance in the resin material serving as the base material. As the light-reflecting substance, it is preferable to use a member that hardly absorbs light from the first light-emitting element 21, the second light-emitting element 22, and the third light-emitting element 23 and has a large refractive index difference from the resin material serving as the base material. As the light-reflecting substance, for example, titanium oxide, zinc oxide, silicon oxide, zirconium oxide, aluminum oxide, and aluminum nitride can be used. The reflective member 7 may contain a light-absorbing substance in the resin material serving as the base material. As the light-absorbing substance, a dark pigment, such as carbon black and the like, can be used. For example, the reflective member 7 may be composed of an inorganic material containing boron nitride or alkali metal silicate. The reflective member composed of the inorganic material may further contain titanium oxide or zirconium oxide.

In the light-emitting device 100a, it is preferable that the reflective member 7 is separated from the first light-emitting element 21, the second light-emitting element 22, and the third light-emitting element 23. When the reflective member 7 is separated from the light-emitting elements, the reflective member 7 can facilitate extraction of light from the lateral surfaces of the first light-emitting element 21, the second light-emitting element 22, and the third light-emitting element 23. The reflective member 7 can be formed by, for example, applying an uncured reflective member on the integrated circuit using a nozzle and then curing the uncured reflective member.

Effects other than those described in the present embodiment are the same as those of the light-emitting device 100 according to the first embodiment.

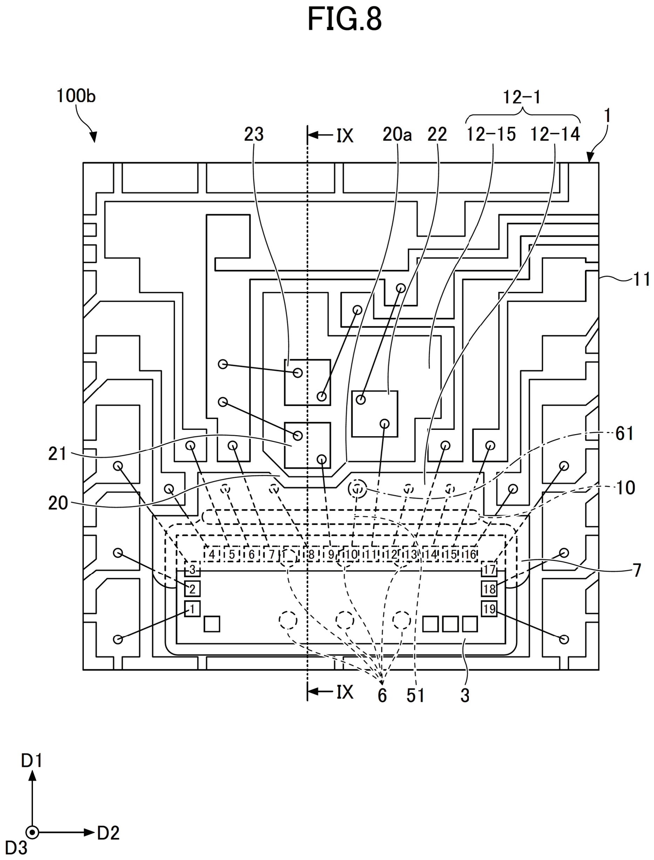

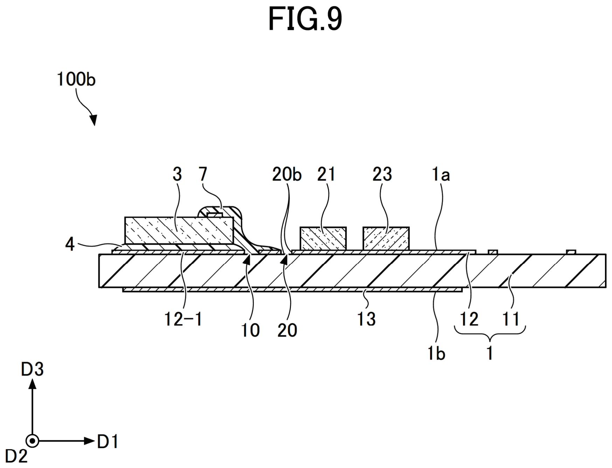

[Third Embodiment] Next, a light-emitting device according to a third embodiment will be described with reference to FIGS. 8 and 9. FIG. 8 is a schematic top view of a light-emitting device 100b according to the third embodiment. FIG. 9 is a schematic cross-sectional view of FIG. 8 along a line IX-IX.

As shown in FIGS. 8 and 9, the light-emitting device 100b according to the present embodiment differs from the light-emitting device 100a according to the second embodiment in that the support body 1 includes a second recess 20 between the connection part 61 and the first light-emitting element 21 in the first direction D1.

In the example shown in FIG. 8, with the second recess 20 included in the support body 1, the first conductive part 12-1 includes a conductive member 12-14 in which the integrated circuit 3 is disposed, and a conductive member 12-15 in which the first light-emitting element 21, the second light-emitting element 22, and the third light-emitting element 23 are disposed. The conductive member 12-14 and the conductive member 12-15 are located apart from each other.

As shown in FIG. 9, the second recess 20 is a part recessed downward from the upper surface 1a of the support body 1. In the example shown in FIG. 9, the second recess 20 is composed of a hole formed in a part of the conductive member 12 disposed on the substrate 11 and penetrating the conductive member 12 from the upper surface to the lower surface thereof. The inner surfaces 20b of the second recess 20 are defined by the substrate 11 and the conductive member 12. However, the second recess 20 is not limited to a hole penetrating the conductive member 12 from the upper surface to the lower surface thereof. For example, the second recess 20 may be composed of a depression that does not penetrate the conductive member 12, or may be composed of a hole penetrating the conductive member 12 and the substrate 11 from the upper surface of the conductive member 12 to the lower surface 1b of the substrate 11. Furthermore, the second recess 20 may be composed of a hole penetrating the conductive member 12 from the upper surface to the lower surface thereof, and a depression that coincides with the hole in a top view and that does not penetrate the substrate 11.

In the example shown in FIG. 8, the second recess 20 includes a plurality of bent parts 20a in a top view, and extends in the second direction D2. However, the shape of the second recess 20 in a top view can be appropriately changed. The second recess 20 may be a depression that does not divide the first conductive part 12-1 into the conductive member 12-14 and the conductive member 12-15, and that is formed in a part of the first conductive part 12-1 in a top view. Further, the second recess 20 may have a shape including a curved part in a top view.

For example, in the case of the light-emitting device having the reflective member 7, because the reflective member 7 has fluidity until it solidifies after being disposed on the support body in the manufacturing process of the light-emitting device, the reflective member 7 may wet-spread over the support body. When the reflective member 7 disposed on the support body wet-spreads and comes into contact with the light-emitting element disposed on the support body, there may be a case in which the light emitted from the light-emitting element is blocked by the reflective member 7, resulting in decrease of the light extraction efficiency of the light-emitting device.

In the present embodiment, the second recess 20 is positioned between the connection part 61 and the first light-emitting element 21 in the first direction D1. Even if the reflective member 7 disposed on the support body 1 wet-spreads in the process of manufacturing the light-emitting device 100, the second recess 20 inhibits the reflective member 7 from wet-spreading toward the first light-emitting element 21, the second light-emitting element 22, or the third light-emitting element 23 disposed on the support body 1. Accordingly, the reflective member 7 can be inhibited from wet-spreading toward the first light-emitting element 21, the second light-emitting element 22, or the third light-emitting element 23. Thus, the reflective member 7 disposed on the support body 1 is less likely to come into contact with the first light-emitting element 21, the second light-emitting element 22, or the third light-emitting element 23, so that the light extraction efficiency of the light-emitting device 100b can be improved. The effects other than those described in the present embodiment are the same as those of the light-emitting device 100a according to the second embodiment.

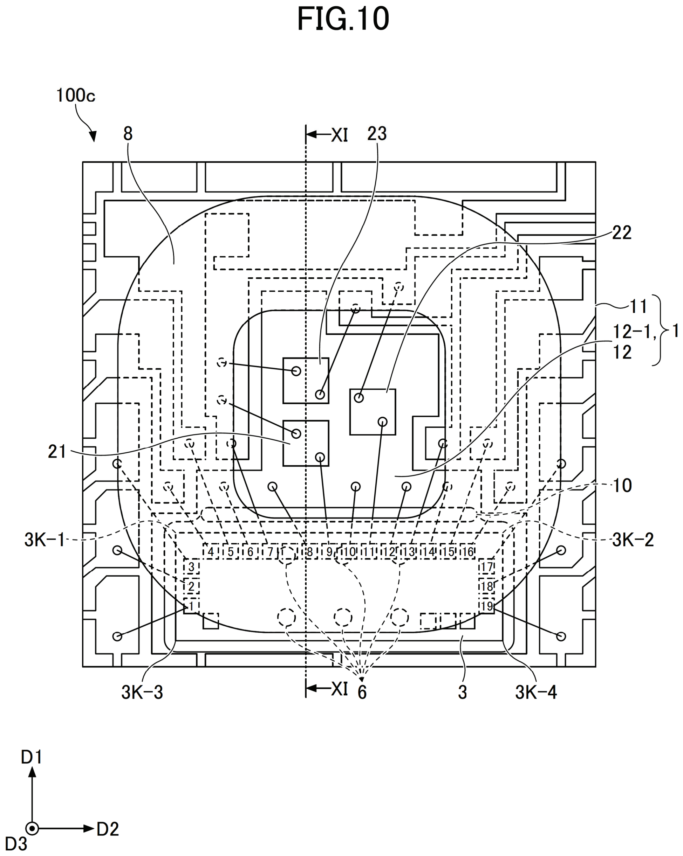

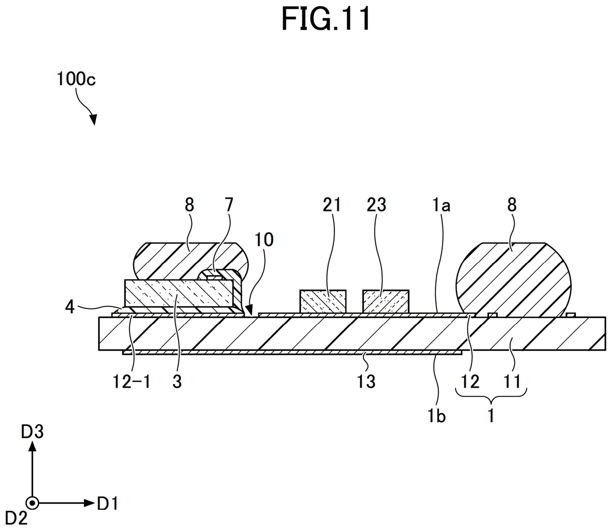

[Fourth Embodiment] Next, a light-emitting device according to a fourth embodiment will be described with reference to FIGS. 10 and 11. FIG. 10 is a schematic top view of a light-emitting device 100c according to the fourth embodiment. FIG. 11 is a schematic cross-sectional view of FIG. 10 along a line XI-XI.

As shown in FIGS. 10 and 11, the light-emitting device 100c according to the present embodiment includes a frame 8 surrounding the first light-emitting element 21 in a top view. The outer edges of the integrated circuit 3 are in a rectangular shape. Among four corners 3K-1, 3K-2, 3K-3, and 3K-4 of the integrated circuit 3, two corners 3K-1 and 3K-2 located on a side where the first light-emitting element 21 is located are covered by the frame 8, and two corners 3K-3 and 3K-4 located on a side opposite to the side where the first light-emitting element 21 is located are exposed from the frame 8. The light-emitting device 100c according to the present embodiment differs from the light-emitting device 100a according to the second embodiment in the configurations described above.

In the example shown in FIG. 10, the frame 8 surrounds the entire circumference of the first light-emitting element 21, the second light-emitting element 22, and the third light-emitting element 23 continuously. In other words, the first light-emitting element 21, the second light-emitting element 22, and the third light-emitting element 23 are located within the region surrounded by the frame 8 continuously. However, the frame 8 may surround the entire circumference of at least the first light-emitting element 21 continuously, or may surround the circumference of at least the first light-emitting element 21 discontinuously. The frame 8 can be composed of the same material as that of the reflective member 7 described in the second embodiment.

In the present embodiment, with the first light-emitting element 21 surrounded by the frame 8, the light emitted from the first light-emitting element 21 is reflected by the frame 8 and contributes to the light to be emitted from the light-emitting device 100c. Thus, the light extraction efficiency of the light-emitting device 100c can be improved. Furthermore, the frame 8 surrounding the first light-emitting element 21 tends to increase the area by which the upper surface 1a of the support body 1 is covered by the frame 8. This can reduce absorption of the light from the first light-emitting element 21 into the support body 1, and can improve the light extraction efficiency of the light-emitting device 100c.

In the present embodiment, among the four corners 3K-1, 3K-2, 3K-3, and 3K-4 of the integrated circuit 3 in a top view, only the two corners 3K-1 and 3K-2 located on the side where the first light-emitting element 21 is located are covered by the frame 8. Thus, compared with a case where all of the four corners 3K-1, 3K-2, 3K-3, and 3K-4 of the integrated circuit 3 are covered by the frame 8, the area on the support body 1 on which the frame 8 is disposed can be reduced. As a result, the size of the light-emitting device 100c can be reduced.

The effects other than those described in the present embodiment are the same as those of the light-emitting device 100a according to the second embodiment.

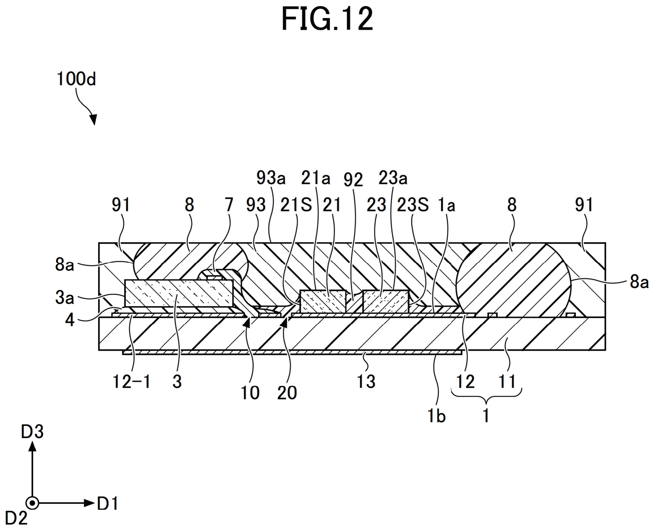

[Fifth Embodiment] Next, a light-emitting device according to a fifth embodiment will be described with reference to FIG. 12. FIG. 12 is a schematic cross-sectional view of a light-emitting device 100d according to the fifth embodiment. FIG. 12 shows a cross-section of the light-emitting device 100d corresponding the cross-section of FIG. 10 along the line XI-XI.

The light-emitting device 100d according to the present embodiment is mainly different from the light-emitting device 100c according to the fourth embodiment in that it further includes a cover member 91 covering outer lateral surfaces of each of the frame 8 and the integrated circuit 3.

In the example shown in FIG. 12, the light-emitting device 100d includes a second reflective member 92 covering the lateral surfaces 21S of the first light-emitting element 21, the lateral surfaces 23S of the third light-emitting element 23, and the upper surface 1a of the support body 1, a second cover member 93 covering the upper surface 21a of the first light-emitting element 21 and the upper surface 23a of the third light-emitting element 23, and a second recess 20. The cover member 91 covers the outer lateral surface 8a of the frame 8 and the outer lateral surface 3a of the integrated circuit 3. The outer lateral surface 8a of the frame 8 refers to a lateral surface of the frame 8 located on a side opposite to a lateral surface of the frame 8 facing the first light-emitting element 21 in a cross-sectional view. The outer lateral surface 3a of the integrated circuit 3 refers to a lateral surface of the integrated circuit 3 located on a side opposite to a lateral surface of the integrated circuit 3 facing the first light-emitting element 21 in a cross-sectional view.

In the present embodiment, by covering the outer lateral surface 8a of the frame 8 and the outer lateral surface 3a of the integrated circuit 3 with the cover member 91, it is possible to reduce external forces being applied to the frame 8 and the integrated circuit 3. Thus, the frame 8 and the integrated circuit 3 can be protected from external forces.

In the present embodiment, the upper surface 21a of the first light-emitting element 21 and the upper surface 23a of the third light-emitting element 23 are covered by the second cover member 93. This can protect the upper surface 21a of the first light-emitting element 21 and the upper surface 23a of the third light-emitting element 23 from external forces. The second cover member 93 may cover the upper surface of the second light-emitting element 22. In the present embodiment, the upper surface 93a of the second cover member 93 is the light-emitting surface of the light-emitting device 100.

The light-emitting device 100d may include the first light-emitting element 21, the second light-emitting element 22, and the third light-emitting element 23. The second reflective member 92 may cover the lateral surfaces of the first light-emitting element 21, the second light-emitting element 22, and the third light-emitting element 23, and the upper surface 1a of the support body 1. The second cover member 93 may cover the upper surfaces of the first light-emitting element 21, the second light-emitting element 22, and the third light-emitting element 23.

### (Cover Member 91)

The cover member 91 contains, for example, a light reflective material that blocks light by reflecting light. The cover member 91 functions to return light emitted from the first light-emitting element 21 and arriving at the cover member 91 through the frame 8 back into the frame 8. Thus, the light extraction efficiency from the light-emitting device 100d can be improved.

Examples of resins used as the base material of the cover member 91 include thermoplastic resin and thermosetting resin. As thermoplastic resin, for example, polyamide resin, polyphthalamide resin, liquid crystal polymers, polybutylene terephthalate (PBT), unsaturated polyester, and the like can be used. As thermosetting resin, for example, epoxy resin, modified epoxy resin, silicone resin, modified silicone resin, and the like can be used.

The cover member 91 can be composed of a resin material, in which particles of a light-reflecting substance are added as a filler to the base material to have light reflectivity. For example, titanium oxide, aluminum oxide, zirconium oxide, magnesium oxide, and the like can be used as the light-reflecting substance. The content of the filler as the light-reflecting substance in the cover member 91 may be 5% by mass or greater and 60% by mass or less, and is preferably 10% by mass or greater and 50% by mass or less. The average particle diameter of the filler is preferably approximately 0.5 µm or greater and 15 µm or less. When the size of the filler is within this range, the cover member 91 can obtain at least one of a good strength or light reflectivity. The cover member 91 may be composed of a member that absorbs light. The cover member 91 may contain a light-absorbing substance in the resin material serving as the base material described above. A dark pigment, such as carbon black and the like, may be used as the light-absorbing substance.

The cover member 91 can be formed by a molding method, such as a transfer mold method using a mold, an injection molding method, a compression molding method, and the like, or a coating method, such as a screen printing method and the like, using a resin material in which the filler is added in the bae material to have at least one of light reflectivity or strength.

### (Second Reflective Member 92)

The second reflective member 92 exposes at least a part of the upper surface 21a of the first light-emitting element 21 and the upper surface 23a of the third light-emitting element 23. The second reflective member 92 can contain a plurality of reflective particles and a base material composed of a light-transmissive material. As the reflective particles, for example, the same light-reflective material as that of the reflective member 7 can be used. As the base material of the second reflective member 92, for example, the same resin material as that of the reflective member 7 can be used. In the second reflective member 92, the reflective particles may or may not settle. From the viewpoint of extracting light from the lateral surfaces of the light-emitting elements, it is preferable that the reflective particles are unevenly distributed, for example, settled. To settle the reflective particles, natural sedimentation, centrifugal sedimentation, or the like can be used. The centrifugal sedimentation can be performed by, for example, using a centrifuge. The second reflective member 92 may be composed of an inorganic material containing, for example, boron nitride and alkali metal silicate. Furthermore, titanium oxide or zirconium oxide may be contained. The second reflective member 92 may only need to cover the lateral surfaces 21S of the first light-emitting element 21 and the upper surface 1a of the support body 1.

### (Second Cover Member 93)

As the base material of the second cover member 93, the same material as the base material of the cover member 91 can be used. The second cover member 93 may contain a plurality of reflective particles. When the second cover member 93 contain a plurality of reflective particles, light emitted from the upper surface 21a of the first light-emitting element 21 and light emitted from the upper surface 23a of the third light-emitting element 23 can readily diffuse in the second cover member 93, which tends to improve the color mixing performance of the light-emitting device 100d. The second cover member 93 may include a wavelength conversion member. The second cover member 93 may only need to cover at least a part of the upper surface 21a of the first light-emitting element 21.

### [Sixth Embodiment]

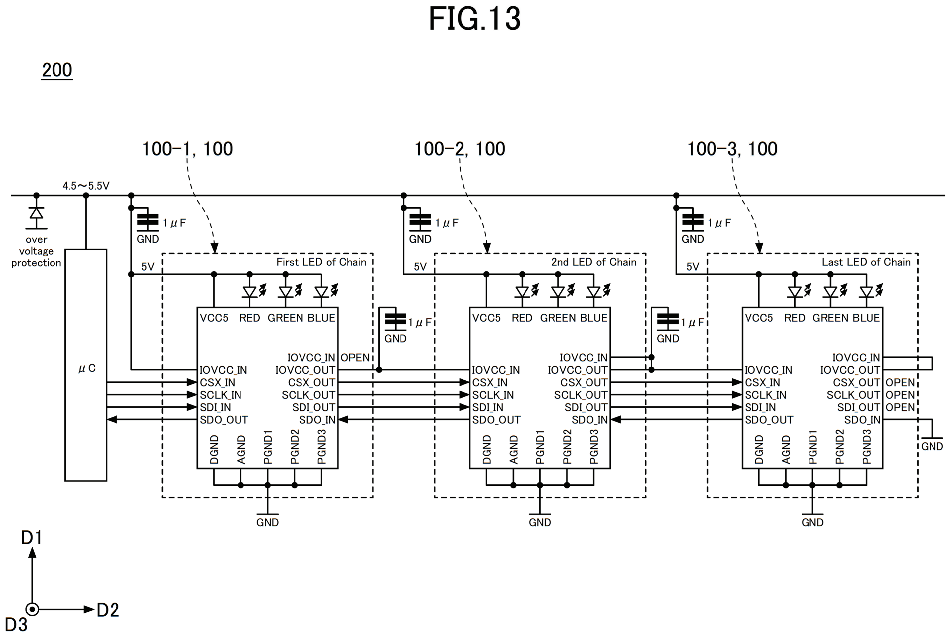

Next, a light-emitting unit according to a sixth embodiment will be described with reference to FIG. 13. FIG. 13 is a schematic diagram showing an example of the system configuration of a light-emitting unit 200 according to the sixth embodiment.

The light-emitting unit 200 shown in FIG. 13 includes a plurality of light-emitting devices 100 according to the first embodiment. The plurality of light-emitting devices 100 are arranged side by side in the second direction D2. In the example shown in FIG. 13, the light-emitting unit 200 includes the plurality of light-emitting devices 100 including a first light-emitting device 100-1, a second light-emitting device 100-2, and a third light-emitting device 100-3. In the present embodiment, the plurality of light-emitting devices 100 being included in the light-emitting unit 200 can improve the reliability of the light-emitting unit 200. The light-emitting unit 200 may include two or more selected from the light-emitting device 100 according to the first embodiment, the light-emitting device 100a according to the second embodiment, the light-emitting device 100b according to the third embodiment, the light-emitting device 100c according to the fourth embodiment, and the light-emitting device 100d according to the fifth embodiment.

Each of the plurality of light-emitting devices 100 shown in FIG. 13 has a built-in Serial Peripheral Interface (SPI), and can communicate with a host controller via the SPI. The SPI is composed of signal lines including four types of signal lines, namely, chip select, clock, and data lines (SDI and SDO). In the SPI, a clock signal is transmitted from the main, which is the host controller, to the light-emitting device 100, which is a replica, and the replica transmits or receives data in synchronization with the clock signal from the main. The main can control the plurality of light-emitting devices 100. The light-emitting unit 200 connects the plurality of light-emitting devices 100 by daisy chaining. In the daisy chaining, one light-emitting device 100 is connected to the main, and the light-emitting device 100 connected to the main and the other plurality of light-emitting devices 100 are connected serially. While receiving data transmitted from the main, the light-emitting devices 100 transmit the data to the next light-emitting devices 100. Each of the plurality of light-emitting devices 100 can exchange data with the preceding light-emitting device 100 and the succeeding light-emitting device 100. In the light-emitting unit 200, connecting the plurality of light-emitting devices 100 by daisy chaining allows them to be controlled by a single main, such as a microcontroller and the like.

The conductive member 12-5 is connected to an input terminal that receives an electric signal from an adjacent light-emitting devices 100 among the plurality of light-emitting devices 100. The conductive member 12-10 is connected to an output terminal that outputs an electric signal to an adjacent light-emitting devices 100 among the plurality of light-emitting devices 100. In other words, in the light-emitting unit 200 shown in FIG. 13, the plurality of light-emitting devices 100 are linked by daisy chaining.

More specific descriptions will be provided below. In the first light-emitting device 100-1, the conductive member 12-13 receives data SDO_IN from the second light-emitting device 100-2. In the first light-emitting device 100-1, the conductive member 12-10 outputs a chip select signal CSX_OUT, the conductive member 12-11 outputs a clock signal SCLK_OUT, and the conductive member 12-12 outputs a data signal SDI_OUT, respectively, to the adjacent second light-emitting device 100-2.

In the second light-emitting device 100-2, the conductive member 12-5 receives a chip select signal CSX_IN, the conductive member 12-4 receives a clock signal SCLK_IN, and the conductive member 12-3 receives a data signal SDI_IN, respectively, from the adjacent first light-emitting device 100-1. In addition, the conductive member 12-2 outputs the data SDO_OUT to the adjacent first light-emitting device 100-1. The conductive member 12-10 outputs a chip select signal CSX_OUT, the conductive member 12-11 outputs a clock signal SCLK_OUT, and the conductive member 12-12 outputs a data signal SDI_OUT, respectively, to the adjacent third light-emitting device 100-3.

In the third light-emitting device 100-3, the conductive member 12-5 receives a chip select signal CSX_IN, the conductive member 12-4 receives a clock signal SCLK_IN, and the conductive member 12-3 receives a data signal SDI_IN, respectively, from the adjacent second light-emitting device 100-2. The conductive member 12-2 outputs data SDO_OUT to the adjacent second light-emitting devices 100-2.

By connecting the plurality of light-emitting devices 100 by daisy chaining, it is possible to improve the reliability of the light-emitting unit 200, and to perform wiring, connection management, and the like of the plurality of light-emitting devices 100 included in the light-emitting unit 200 efficiently.

The support body 1 of each of the plurality of light-emitting devices 100 includes a second conductive part located on one side of the integrated circuit 3 in the second direction D2, and a third conductive part located on the other side of the integrated circuit 3 in the second direction D2. In the example shown in FIG. 13, the "one side" is the left side in a top view, and the "other side" is the right side in a top view. Each of the conductive member 12-2, the conductive member 12-3, the conductive member 12-4, and the conductive member 12-5 shown in FIG. 1 corresponds to the second conductive part. Each of the conductive member 12-13, the conductive member 12-12, the conductive member 12-11, and the conductive member 12-10 shown in FIG. 1 corresponds to the third conductive part.

Each of the second conductive part and the third conductive part can either receive or output an electric signal. The second conductive part and the third conductive part being included in the light-emitting unit 200 can increase the number of inputs and outputs of electric signals on each of the plurality of light-emitting devices 100 without increasing the size of the light-emitting unit 200 in the first direction D1, and can increase the degree of latitude in controlling each of the plurality of light-emitting devices 100.

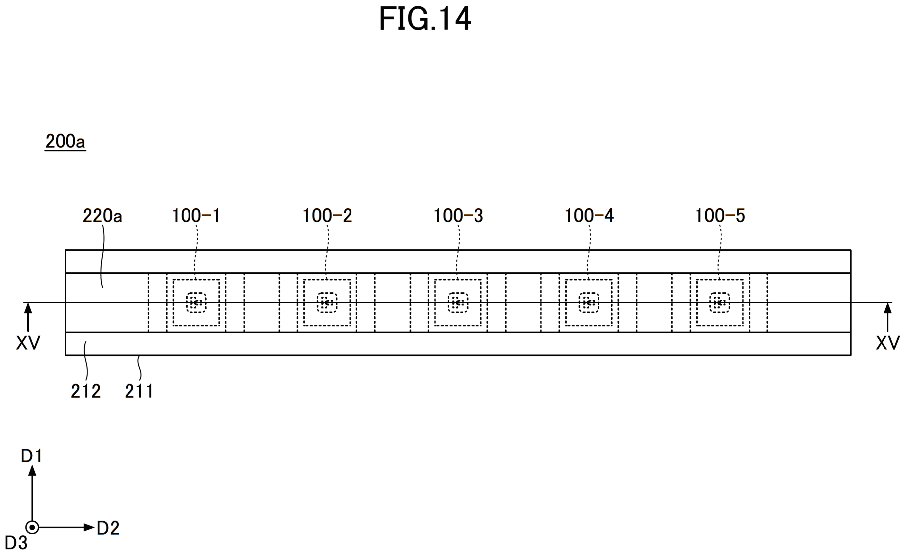

[Seventh Embodiment] Next, a light-emitting unit according to the seventh embodiment will be described with reference to FIGS. 14 to 17. The light-emitting unit according to the present embodiment is different from the light-emitting unit 200 according to the sixth embodiment in that it includes a plurality of light-emitting devices 100 and a light-guiding member disposed above the plurality of light-emitting devices 100 and guiding light emitted from the plurality of light-emitting devices 100.

### (First Example)

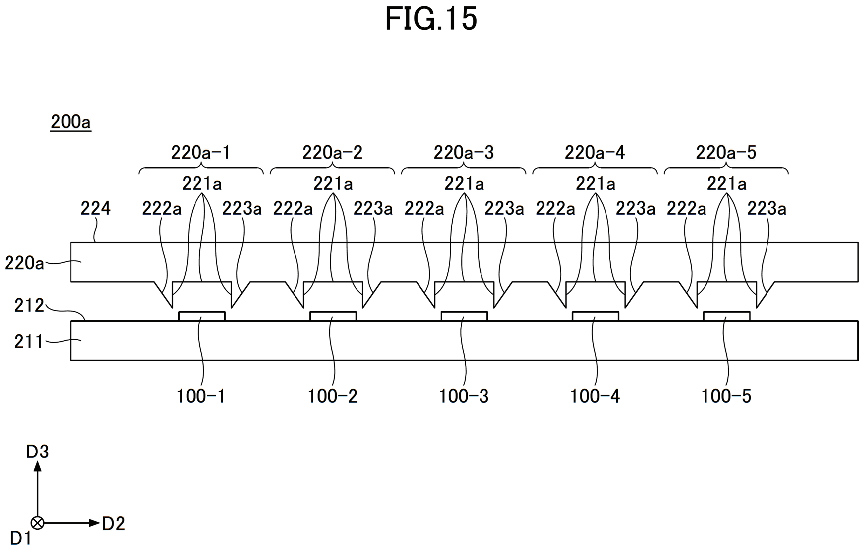

FIG. 14 is a schematic top view showing a light-emitting unit 200a according to a first example. FIG. 15 is a schematic cross-sectional view of FIG. 14 along a line XV-XV.

The light-emitting unit 200a includes a substrate 211, a first light-emitting device 100-1, a second light-emitting device 100-2, a third light-emitting device 100-3, a fourth light-emitting device 100-4, a fifth light-emitting device 100-5, and a light-guiding member 220a. The light-emitting unit 200a is a light-emitting unit used in, for example, ambient lighting.

In the first example shown in FIG. 14, the first light-emitting device 100-1, the second light-emitting device 100-2, the third light-emitting device 100-3, the fourth light-emitting device 100-4, and the fifth light-emitting device 100-5 are disposed on the upper surface 212 of the substrate 211 side by side in the second direction D2. Any of the light-emitting device 100, the light-emitting device 100a, the light-emitting device 100b, or the light-emitting device 100c can be applied as the first light-emitting device 100-1, the second light-emitting device 100-2, the third light-emitting device 100-3, the fourth light-emitting device 100-4, and the fifth light-emitting device 100-5. In the following description, for the convenience of explanation, the first light-emitting device 100-1, the second light-emitting device 100-2, the third light-emitting device 100-3, the fourth light-emitting device 100-4, and the fifth light-emitting device 100-5 may be collectively referred to as the light-emitting devices 100 when they are not distinguished from each other.

The light-guiding member 220a is a member that causes light emitted from the plurality of light-emitting devices 100 to enter the interior of the light-guiding member 220a, guides the light in the light-guiding member 220a, and then outputs the light from the interior of the light-guiding member 220a to the outside. The light-guiding member 220a is fixed so as to be positioned above the first light-emitting device 100-1, the second light-emitting device 100-2, the third light-emitting device 100-3, and the fourth light-emitting device 100-4. In a top view, the light-guiding member 220a has a substantially rectangular outer shape that is elongated in the second direction D2 in which the first light-emitting device 100-1, the second light-emitting device 100-2, the third light-emitting device 100-3, and the fourth light-emitting device 100-4 are disposed side by side. It is preferable that the light-guiding member 220a has, for example, a transmittance of 60% or higher for light emitted from the light-emitting devices 100.

The light-guiding member 220a includes a first light-guiding part 220a-1, a second light-guiding part 220a-2, a third light-guiding part 220a-3, a fourth light-guiding part 220a-4, a fifth light-guiding part 220a-5, and a light-outputting part 224. The first light-guiding part 220a-1 is disposed above the first light-emitting device 100-1 and guides light from the first light-emitting device 100-1. The second light-guiding part 220a-2 is disposed above the second light-emitting device 100-2 and guides light from the second light-emitting device 100-2. The third light-guiding part 220a-3 is disposed above the third light-emitting device 100-3 and guides light from the third light-emitting device 100-3. The fourth light-guiding part 220a-4 is disposed above the fourth light-emitting device 100-4 and guides light from the fourth light-emitting device 100-4. The fifth light-guiding part 220a-5 is disposed above the fifth light-emitting device 100-5 and guides light from the fifth light-emitting device 100-5.

The first light-guiding part 220a-1, the second light-guiding part 220a-2, the third light-guiding part 220a-3, the fourth light-guiding part 220a-4, and the fifth light-guiding part 220a-5 each include a light-incident part 221a, a first reflective part 222a, and a second reflective part 223a.

The light-incident part 221a shown in FIG. 15 is a part through which light from the light-emitting device 100 passes when entering the interior of the light-guiding member 220a. The light-incident part 221a constitutes a recess that is recessed upward in a cross-sectional view including the second direction D2 and the third direction D3. The light-incident part 221a has a substantially rectangular outer shape in a top view shown in FIG. 14.

The first reflective part 222a and the second reflective part 223a reflect upward a part of the light incident through the light-incident part 221a that reaches the first reflective part 222a and the second reflective part 223a. The first reflective part 222a and the second reflective part 223a are arranged side by side in the second direction D2 with the light-incident part 221a interposed.

A part of the light passing through the light-incident part 221a and guided in the interior of the light-guiding member 220a is output from the light-guiding member 220a through the light-outputting part 224. Another part of the light passing through the light-incident part 221a and transmitted through the interior of the light-guiding member 220a is reflected by the first reflective part 222a or the second reflective part 223a and then output from the light-guiding member 220a through the light-outputting part 224. The light-outputting part 224 is a light-outputting part that is common to the first light-guiding part 220a-1, the second light-guiding part 220a-2, the third light-guiding part 220a-3, the fourth light-guiding part 220a-4, and the fifth light-guiding part 220a-5.

In the light-emitting unit 200a, light emitted from the first light-emitting device 100-1, the second light-emitting device 100-2, the third light-emitting device 100-3, the fourth light-emitting device 100-4, and the fifth light-emitting device 100-5 is guided by the light-guiding member 220a. This makes it possible to control the light distribution of the light that is output from the light-guiding member 220a.

### (Second Example)

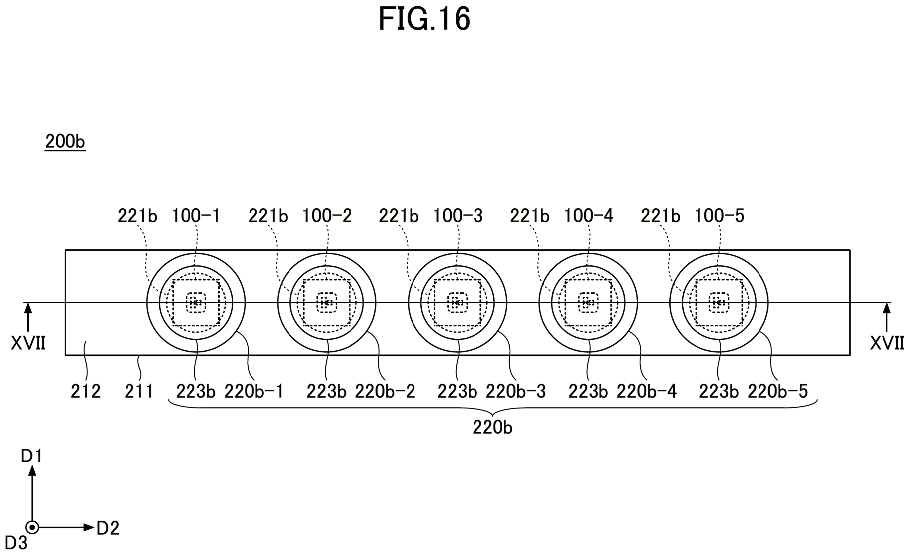

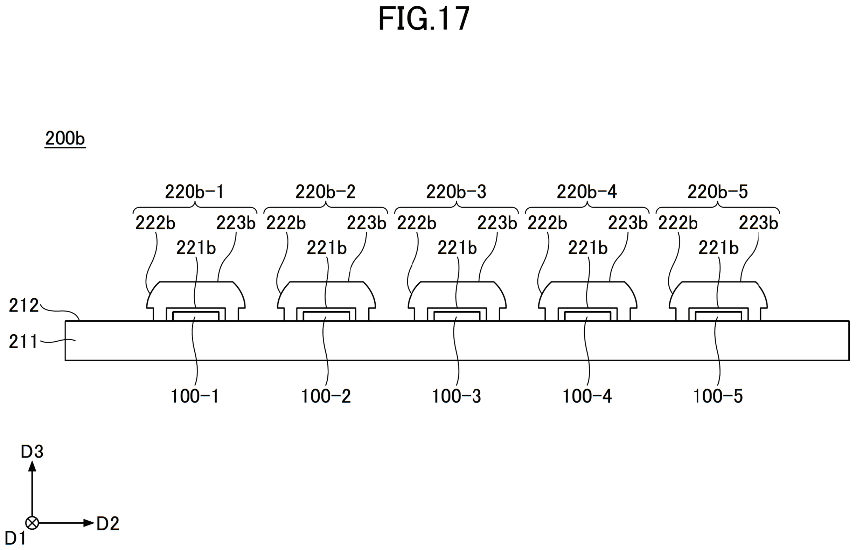

FIG. 16 is a schematic top view showing a light-emitting unit 200b according to a second example. FIG. 17 is a schematic cross-sectional view of FIG. 16 along a line XVII-XVII. In the top view of FIG. 16, a part of the structures corresponding to the cross-sectional view of FIG. 17 may be omitted to avoid excessive complicating the drawing.

The light-emitting unit 200b includes a substrate 211, a first light-emitting device 100-1, a second light-emitting device 100-2, a third light-emitting device 100-3, a fourth light-emitting device 100-4, a fifth light-emitting device 100-5, and a light-guiding member 220b. The light-emitting unit 200b is a light-emitting unit used as a backlight for a liquid crystal display panel and the like.

In the second example shown in FIG. 16, the first light-emitting device 100-1, the second light-emitting device 100-2, the third light-emitting device 100-3, the fourth light-emitting device 100-4, and the fifth light-emitting device 100-5 are disposed on the top surface 212 of the substrate 211 side by side in the second direction D2. Any of the light-emitting device 100, the light-emitting device 100a, the light-emitting device 100b, or the light-emitting device 100c can be applied as the first light-emitting device 100-1, the second light-emitting device 100-2, the third light-emitting device 100-3, the fourth light-emitting device 100-4, and the fifth light-emitting device 100-5.

The light-guiding member 220b includes a first light-guiding member 220b-1, a second light-guiding member 220b-2, a third light-guiding member 220b-3, a fourth light-guiding member 220b-4, and a fifth light-guiding member 220b-5.

The first light-guiding member 220b-1 is disposed above the first light-emitting device 100-1. The first light-guiding member 220b-1 is a member that causes light emitted from the first light-emitting device 100-1 to enter the interior of the first light-guiding member 220b-1, guides the light in the interior of the first light-guiding member 220b-1, and then outputs the light from the interior of the first light-guiding member 220b-1 to the outside.

The second light-guiding member 220b-2 is disposed above the second light-emitting device 100-2. The second light-guiding member 220b-2 is a member that causes light emitted from the second light-emitting device 100-2 to enter the interior of the second light-guiding member 220b-2, guides the light in the interior of the second light-guiding member 220b-2, and then outputs the light from the interior of the second light-guiding member 220b-2 to the outside.

The third light-guiding member 220b-3 is disposed above the third light-emitting device 100-3. The third light-guiding member 220b-3 is a member that causes light emitted from the third light-emitting device 100-3 to enter the interior of the third light-guiding member 220b-3, guides the light in the interior of the third light-guiding member 220b-3, and then outputs the light from the interior of the third light-guiding member 220b-3 to the outside.

The fourth light-guiding member 220b-4 is disposed above the fourth light-emitting device 100-4. The fourth light-guiding member 220b-4 is a member that causes light emitted from the fourth light-emitting device 100-4 to enter the interior of the fourth light-guiding member 220b-4, guides the light in the interior of the fourth light-guiding member 220b-4, and then outputs the light from the interior of the fourth light-guiding member 220b-4 to the outside.

The fifth light-guiding member 220b-5 is disposed above the fifth light-emitting device 100-5. The fifth light-guiding member 220b-5 is a member that causes light emitted from the fifth light-emitting device 100-5 to enter the interior of the fifth light-guiding member 220b-5, guides the light in the interior of the fifth light-guiding member 220b-5, and then outputs the light from the interior of the fifth light-guiding member 220b-5 to the outside.

It is preferable that the first light-guiding member 220b-1, the second light-guiding member 220b-2, the third light-guiding member 220b-3, the fourth light-guiding member 220b-4, and the fifth light-guiding member 220b-5 each have a substantially circular outer shape in a top view and have a transmittance of 60% or higher for the light emitted from the light-emitting devices 100. The first light-guiding member 220b-1, the second light-guiding member 220b-2, the third light-guiding member 220b-3, the fourth light-guiding member 220b-4, and the fifth light-guiding member 220b-5 each include a light-incident part 221b, a first light-outputting part 222b, and a second light-outputting part 223b.

The light-incident part 221b is a substantially flat part through which the light from the light-emitting device 100 passes when entering the interior of the light-guiding member 220b. The light-incident part 221b has a substantially circular outer shape in a top view.

The first light-outputting part 222b is a curved surface part through which a part of the light emitted from the light-emitting device 100 and transmitted through the interior of the light-guiding member 220b passes when being output from the light-guiding member 220b. The first light-outputting part 222b has a substantially circular annular shape in a top view.

The second light-outputting part 223b is a substantially flat part through which a part of the light emitted from the light-emitting device 100 and transmitted through the interior of the light-guiding member 220b passes when being output from the light-guiding member 220b. The second light-outputting part 223b has a substantially circular outer shape in a top view.

In the light-emitting unit 200b, the light emitted from the first light-emitting device 100-1, the second light-emitting device 100-2, the third light-emitting device 100-3, the fourth light-emitting device 100-4, and the fifth light-emitting device 100-5 is guided by the light-guiding member 220b. This makes it possible to control the light distribution of the light that is output from the light-guiding member 220b.

The light-guiding member of the light-emitting unit according to the present embodiment is not limited to the light-guiding member 220a shown in the first example and the light-guiding member 220b shown in the second example. The light-guiding member of the light-emitting unit according to the present embodiment may be, for example, one or more convex lenses, one or more concave lenses, one or more meniscus lenses, one or more Fresnel lenses, one or more diffractive lenses, and one or more cylindrical lenses, or combinations thereof.

The preferred embodiments have been described above in detail. However, the above-described embodiments are non-limiting, and various modifications and substitutions are applicable to the above-described embodiments without departing from the scope of claims.

All numerals, such as ordinals, quantities, and the like, used in the description of the embodiments are exemplified for the purpose of specifically describing the techniques of the present disclosure, and the present disclosure is not limited to the exemplified numerals. Furthermore, the connection relationship between the components is exemplified for the purpose of specifically describing the technique of the present disclosure, and the connection relationship for realizing the functions of the present disclosure is not limited to this.

Because the light-emitting device and the light-emitting unit of the present disclosure can improve the reliability of the light-emitting device, they can be suitably used as, for example, a light-emitting device, a lighting device, and the like for the interior of vehicles, such as automobiles and the like. However, the light-emitting device and the light-emitting unit of the present disclosure are not limited to a light-emitting device and a lighting device for the interior of vehicles, and can be used for various purposes.

## Claims

1. A light-emitting device, comprising:
a support body comprising:
a substrate, and
a plurality of conductive members supported by the substrate, the plurality of conductive members including a first conductive part, wherein:
the support body has a first recess in an upper surface of the support body;
a first light-emitting element disposed on the support body;
an integrated circuit extending in a first direction and a second direction orthogonal to the first direction in a top view, the integrated circuit disposed on the support body such that the integrated circuit and the first light-emitting element are in a row in the first direction;
a joining member disposed between the support body and the integrated circuit and joining the support body and the integrated circuit; and
a first wire connected to the first conductive part and to the integrated circuit, wherein, in the first direction, the first recess is located between a connection part, at which the first conductive part and the first wire are connected to each other, and the integrated circuit.

2. The light-emitting device according to claim 1, wherein a maximum length of the first recess in the second direction is longer than a maximum length of the first recess in the first direction.

3. The light-emitting device according to claim 1 or 2, wherein inner surfaces of the first recess are defined by the substrate and the conductive member.

4. The light-emitting device according to any one of claims 1 to 3, wherein a maximum length of the first recess in the second direction is longer than a maximum length of the first light-emitting element in the second direction.

5. The light-emitting device according to any one of claims 1 to 4, wherein:
among the plurality of conductive members, a conductive member located immediately under the first light-emitting element includes a first part that, in a top view, overlaps the first light-emitting element in the second direction; and
a maximum length of the first recess in the second direction is longer than a maximum length of the first part in the second direction.

6. The light-emitting device according to any one of claims 1 to 5, wherein a maximum length of the first recess in the second direction is shorter than a maximum length of the integrated circuit in the second direction.

7. The light-emitting device according to any one of claims 1 to 6, wherein the integrated circuit is located on the first conductive part.

8. The light-emitting device according to any one of claims 1 to 7, comprising:
a plurality of wires each connected to the integrated circuit, the plurality of wires including said first wire; wherein:
in the top view, the integrated circuit includes:
a first outer edge facing the first light-emitting element,
a second outer edge located on a side opposite to the first outer edge,
a third outer edge connected to the first outer edge and the second outer edge, and
a fourth outer edge located on a side opposite to the third outer edge;
and
the plurality of wires do not overlap the second outer edge in the top view.

9. The light-emitting device according to any one of claims 1 to 8, wherein:
the support body includes a via electrically connected to the first conductive part; and
the integrated circuit overlaps the via in the top view.

10. The light-emitting device according to any one of claims 1 to 9, further comprising:
a reflective member covering at least a part of a lateral surface of the integrated circuit, the lateral surface facing the first light-emitting element.

11. The light-emitting device according to claim 10, wherein:
in the top view, outer edges of the integrated circuit are in a rectangular shape; and
among four corners of the integrated circuit in the top view, two of the corners located on a side where the first light-emitting element is located are covered by the reflective member, and two of the corners located on a side opposite to the side where the first light-emitting element is located are exposed from the reflective member.

12. The light-emitting device according to claim 10 or 11, wherein the support body includes a second recess between the connection part and the first light-emitting element in the first direction.

13. The light-emitting device according to any one of claims 1 to 12, further comprising:
a frame surrounding the first light-emitting element in the top view; wherein:
an outer edge of the integrated circuit has a rectangular shape; and
among four corners of the integrated circuit, two of the corners located on a side where the first light-emitting element is located are covered by the frame, and two of the corners located on a side opposite to the side where the first light-emitting element is located are exposed from the frame.

14. The light-emitting device according to claim 13, further comprising:
a cover member covering an outer lateral surface of each of the frame and the integrated circuit.
